# EUROPEAN PATENT APPLICATION

(11) **EP 3 751 623 A1**
(43) Date of publication of application: **16.12.2020**
(21) Application number: 19750740.3
(22) Date of filing: 31.01.2019
(51) Int. Cl.: H01L 31/04

(54) **POWER-GENERATING BUILDING MATERIAL AND PREPARATION METHOD THEREFOR**

(30) Priority: 08.02.2018 CN 201810128516
(71) Applicant: PHOTON TECHNOLOGY (KUNSHAN) CO., LTD, Suzhou, Jiangsu 215300 (CN)
(72) Inventor: ZHANG, Wei, Suzhou, Jiangsu 215300 (CN); LI, Yongwu, Suzhou, Jiangsu 215300 (CN)
(74) Representative: CAPRI
(86) International application number: PCT/CN2019/074214
(87) International publication number: WO 2019/154277

(57) **Abstract**

A power-generating building material, comprising a substrate (1), a power-generating layer (2) and a protective layer (4), wherein the power-generating layer (2) is disposed on the substrate (1), and the protective layer (4) covers the power-generating layer (2). The substrate (1) is glass, metal plate, cement-based board, flexible plastic film, ceramic or tile, and the protective layer (4) has a weighted average transmittance of 0% to 79% in a wavelength range of 300 nm to 1300 nm. A process for preparing the power-generating building material, comprises: 1) cleaning the surface of the substrate; 2) attaching the power-generating layer to the substrate and extracting a positive electrode and a negative electrode; and 3) coating a protective layer on the solar cells.

## Description

### Cross-Reference to Related Application

The present application claims the benefits of the Chinese Patent Application No. 201810128516.2 filed on February 8, 2018, which is incorporated by reference herein in its entirety.

### Field

The present disclosure generally relates to the construction field, and more specifically relates to a power-generating building material and a preparation process thereof, and a photovotaic building material and a preparation process thereof.

### Background

As the society develops, the demand of energy for human grows as well. However, the fossil fuels of the world are dying down slowly, and the environmental pollution is becoming more and more serious. It is a common sense for all humans to develop clean and renewable energy.

However, due to the restriction of process in the art, solar cells cannot fuse into the architectural environment where they are installed. On one hand, the installation of solar cells usually changes or adds the original external structure or additional facilities of the buildings. On the other hand, the installation *per se* also affects the artistic value and humanistic beauty of the buildings.

Chinese Utility Model CN2730982Y discloses a solar ceramic. The technical solution is to coat the surface of inorganic clay of industrial ceramic with vitreous coating agents and sinter to form a substrate of ceramic; dispose a power-generating layer that carries out photoelectric conversion on the surface of the substrate of the ceramic; dispose transparent conductive films on the upper and lower surfaces of the power-generating layer; and utilize the electrical current generated on the power-generating layer by transparent conductive films. The power-generating layer has n type silicon layer-i type silicon layer-p type silicon layer structure or p type silicon layer-i type silicon layer-n type silicon layer structure. The vitreous coating agents can be phosphosilicate glass or borosilicate glass. In order to prevent the reflection of sunlight, an anti-reflection protective film comprising titanium oxide and silicon oxide is formed on the transparent conductive film.

However, the above-mentioned solar ceramics have the following defects: 1. Since the silicon based solar cells are easily affected by the environment, they usually need to be encapsulated with a special polymer before it can be used outdoors in the photovoltaic field. But the anti-reflection protective film on transparent conductive film structure can hardly protect the cells or meet the standard of the photovoltaic industry. 2. The above anti-reflection protective film is a transparent material. Therefore, it can allow most of the light to shine directly on the surface of the solar cell. As a result, the color formed by reflection will be the actual color of the cell itself. The color cannot be changed and cannot show the texture of the surface of buildings.

Chinese Patent for Invention CN101755343A discloses a process for preparing a ceramic comprising photovoltaic cells. The process comprises the following steps:
preparing the ceramic substrate (2), which has one or more through holes (2c) and has a hydroscopicity of equal or less than 0.5 wt%. This step comprises the following steps:
pressing process, in which the atomized ceramic powders with 3 wt% to 6 wt% humidity are pressed under the pressure of 35 MPa to 60 MPa;
drying and baking process, in which the maximum temperature for baking is between 1100°C to 1250°C; directly depositing Ag or Ag-Al on the surface (2a) of the ceramic substrate (2) to form the conductive layer (6). The other layers on the substrate are multiple active layers (7), conductive material layer (9) with grid structure, the protective layer (10) and the surface (2b) opposite to the surface (2a) of the ceramic substrate (2). The protective layer (10) is designed to ensure high transmission of solar radiation, moisture resistance, weather resistance, UV stability and electrical insulation. The multiple active layers (7) comprises n-type layer (11), photosensitive layer (12) and p-type layer (13). The conductive connector (5) is set in the through hole (2c) so that the conductive connector (5) electrically connects with the conductive layer (6). One side of the protective layer which receives the sunlight comprises one of the following materials: enamel, polycarbonate, fluorinated polymers, polytrifluoroethylene, or a combination of polymethyl methacrylate and polyfluoroethylene. The protective layer has the following defects:
   (1) The CVD method, preferably plasma enhanced CVD method (PECVD), needs to be employed to deposit the photovoltaic cells on the ceramic substrate. The photovoltaic cells with better performance usually require higher film-forming conditions. It is obvious that it is difficult to form the film in vacuum for ceramic substrate materials. Even if its water content is less than 0.5 wt%, it is still a major obstacle to manufacturing photovoltaic cells with high performance.
   (2) When the protective layer is enamel, since its sintering temperature is 500°C to 900°C, even if a relatively lower temperature is selected to form a transparent enamel layer on the surface, some irreversible damages to the power-generating layer will be incurred.
   (3) When the prepared protective layer is thin, the color of the electrode layer will appear. This makes the photovoltaic cells extremely uncoordinated with the environment, which limits its application environment. Other organic polymer materials are prone to aging in a long-term outdoor environment, resulting in a decrease in light transmittance and waterproof performance, which seriously affects the power generation efficiency, and even results in the risk of falling off from the surface of the buildings, thereby causing the bottom layer of the electrode layer to be exposed.

On the other hand, the new energy resources currently available to people include wind energy, solar energy, ocean energy, geothermal energy, etc., of which production sites are usually located in the suburbs, in the desert or on the ocean with small population and low energy consumption. While in areas with high population density and concentrated consumption such as in cities, the employment of these new energy sources is rarely found. On one hand, it is caused by the lack of concentration of new energy resources. For example, the concentrated areas of wind energy, ocean energy and geothermal energy are not suitable for human habitation. On the other hand, it is because the usage of new energy resources is not mature and reasonable enough. For example, solar energy is widely distributed and there is a large amount of solar energy available in cities with high population density. At present, the main combination of city and solar energy is building integrated photovoltaics (BIPV), but the photovoltaic modules used in conventional BIPV are generally dark blue, gray or black, and their color and texture are unaesthetic. Therefore, it is difficult for them to be integrated with the buildings and meet the aesthetic requirements for architecture. These shortcomings limit the widespread use of photovoltaic modules in buildings.

Based on the above, different types optical anti-reflection films with different thicknesses are adopted so that the crystalline silicon solar cells can exhibit different colors in patent application CN200420085961. An optical dielectric film layer is added between the glass substrate and the transparent conductive film so that a passive filter system, which can selectively reflect and absorb the solar spectrum, is formed with the optical dielectric film layer, the transparent glass substrate, the transparent conductive film and the amorphous silicon film in Patent application CN201020272089. When the incident angle changes, the color of the glass wall changes. That is, the color of the glass wall seen from the front and the side can be different. The match of the building color is achieved by changing the color of EVA or PVB gel film without changing the solar cells layer in Patent application CN201220200568.

Although the above-mentioned patents can make the photovoltaic modules colored and broaden the application range of the photovoltaic modules, these photovoltaic modules exhibit a similar texture to that of glass. That is, they only exhibit single texture and appearance. Therefore, these shortcomings limit the application of the photovoltaic modules in the construction field.

### Summary

In view of various defects existing in solar cells in the prior art, one object of the present disclosure is to provide a power-generating building material. The substrate of the power-generating building material can be selected in a more flexible manner. The power-generating building material can be integrated better with the environment by improving the components of the protective layer material, and a broad application range in practice.

In one aspect, the present disclosure provides a power-generating building material, comprising a substrate, a power-generating layer and a protective layer; wherein the power-generating layer is disposed on the substrate, and a encapsulation layer covers the power-generating layer; the substrate is glass, metal plate, cement-based board, plastic film, ceramic or tile; and the protective layer has a weighted average transmittance of 0% to 79% in a wavelength range of 300 nm to 1300 nm.

As a better choice for the above-mentioned power-generating building materials, the substrate can have a thickness of 0.01 mm to 5 cm. In preferred embodiments, when the substrate has a thickness of 0.01 mm to 0.5 mm, a soft and flexible power-generating building material can be prepared. When the substrate has a thickness of 0.5 mm to 5 cm, a power-generating building material for conventional or special purpose can be prepared.

As a better choice for the above-mentioned power-generating building materials, the power-generating layer has a structure of copper indium gallium selenide (CIGS) thin film solar cell, gallium arsenide (GaAs) solar cell, crystalline silicon solar cell, silicon-based thin-film solar cell, cadmium telluride (CdTe) thin-film solar cell, organic solar cells (OPV), copper zinc tin sulfide (CZTS) thin-film solar cell or perovskite thin-film solar cell.

For the above-mentioned power-generating building materials, even if the light transmittance is lower than 79%, the power-generating building material can still generate electric current. In particular, electric current can also be generated when the transmittance is extremely low.

The material of the protective layer is an inorganic silicate material or an inorganic organic composite material.

As a better choice for the above-mentioned power-generating building materials, the protective layer can have a thickness of 0.01 mm to 5mm.

As a better choice for the above-mentioned power-generating building materials, the power-generating building material further comprises an encapsulation layer located between the power-generating layer and the protective layer. The encapsulation layer material comprises ethylene-octene copolymer or ethylene-vinyl acetate copolymer.

As a better choice for the above-mentioned power-generating building materials, the encapsulation layer material further comprises ethylene-tetrafluoroethylene copolymer (ETFE) material. The ETFE material is located between ethylene-octene copolymer or ethylene-vinyl acetate copolymer and the protective layer.

As a better choice for the above-mentioned power-generating building materials, the encapsulation layer can have a thickness of 0.05 mm to 3 mm.

The encapsulation layer can be arranged as desired. In the embodiments of the present disclosure, all the encapsulation layer materials as used can be removed. The encapsulation layer can further extend the life of the solar cell.

The protective layer has a weighted average transmittance of 0% to 79% in the wavelength range of 300 to 1300 nm. One skilled in the art can further improve the transmittance as desired, such as by adding or doping some components in the raw material for preparing the protective layer so that it can absorb or maintain a high transmittance at a specific wavelength. As a result, transparent or semi-transparent properties in the visible wavelength range, or a specified transmittance (e.g., 50%) can be achieved. More specifically, the chosen wavelength range can be 300 nm to 360 nm, 360 nm to 400 nm, 400 nm to 500 nm, 500 nm to 600 nm, 600 nm to 700 nm, 700 nm to 760 nm, 760 nm to 860 nm or 860 nm to 1300 nm. The protective layer can have different colors by changing the components of the raw material.

As a better choice for the above-mentioned power-generating building materials, the surface of the power-generating layer can further have a graphene film with a thickness of not more than 10 nm. The graphene film can further improve the performance of the power-generating layer.

The power-generating building material has the following properties:
(1) Light and thin. When all the substrate, the protective layer and the power-generating layer are materials with a small thickness, the overall thickness of the power-generating building material can be as low as 28 µm.
(2) Flexible. When all the substrate, the protective layer and the power-generating layer are lighter and thinner materials, the power-generating building material of the present disclosure is flexible, and the specific radius of curvature thereof is not more than 20 mm.
(3) High photoelectric conversion efficiency. The photoelectric conversion efficiency of the power-generating building material of the present disclosure is more than 14%.
(4) Good weak light effects. The solar cell of the present disclosure can generate electricity even in a weak light environment (such as rainy weather or indoor lighting conditions), but the power generation efficiency is lower than that under normal sunlight irradiation. Even if a material with a transmittance of 10% for visible light is used as the protective layer, it can achieve the function of LED lamp or quantum dot luminescence unit by combining with an energy storage unit.

The present disclosure further provides a power-generating building material, wherein the substrate is ceramic. Ceramic is used for decorating the exterior of the building, and can also be used for the construction of road. Ceramic can also be used to supply power for the street lamp and the footlights by combining with energy storage unit.

As a better choice for the above-mentioned power-generating building materials, the solar cells further comprise an insulating and sealing layer. The material of the insulating and sealing layer can be ethylene-octene copolymer (POE) or ethylene-vinyl acetate copolymer (EVA).

The present disclosure further provides a process for preparing the above-mentioned power-generating building material, comprising:
(1) attaching the power-generating layer to the substrate and extracting a positive electrode and a negative electrode, or directly preparing the power-generating layer on the substrate, and extracting a positive electrode and a negative electrode; and
(2) coating a protective layer material at liquid state at room temperature and curing at room temperature over 0.5 hours to 12 hours to form a solid enamel protective layer.

As a better choice for the above-mentioned process, step (1) further comprises forming an encapsulation layer after extracting the positive electrode and negative electrode.

As a better choice for the above-mentioned process, the substrate is treated with polishing and cleaning before preparing the power-generating layer, and the treated substrate has a surface roughness of less than 100 nm and a contact angle of 5 to 15 degrees.

The power-generating building material for construction filed has the following beneficial effects:
1. The substrate has a wide range of sources. There are no special requirements for the substrate, which does not affect the preparation of the product.
2. There is no need for a vacuum system. It can be prepared directly in the normal atmospheric environment without the need to add special equipment.
3. The combination of building materials and photovoltaic field lead to scale production and has great cost advantages.

In another aspect, in view of various defects existing in solar cells in the prior art, the present disclosure provides a photovoltaic building material used in the construction field. The texture and appearance of the photovoltaic building material are no longer limited to the texture and appearance of glass. The texture and appearance of the photovoltaic building material can be the same as the appearance of the natural stones such as marble, granite and the like that are conventionally seen. By changing the formulation of surface layer material of the photovoltaic building material, the building material can have various colorful appearances and rich textures that people want. The photovoltaic building material can develop and use sufficient sunlight radiation on the buildings without destroying the appearance and style of the buildings. The photovoltaic building materials have broad application prospects.

The specific technical solutions of the photovoltaic building materials in the construction field in the present disclosure are as follows.

The present disclosure provides a photovoltaic building material, comprising a surface layer, a power-generating layer and a substrate layer, wherein the surface layer is formed by coating a liquid directly on a surface of the power-generating layer and solidifying, and the surface layer has a weighted average transmittance of 10% to 85% in a wavelength range of 300 nm to 1300 nm.

In preferred embodiments, the surface layer has a thickness of 0.01 mm to 5 mm.

In preferred embodiments, the surface layer has a weighted average transmittance of 45% to 75% in a wavelength range of 300 nm to 1300 nm and a haze of 10% to 99% by changing the thickness, the formulation of raw materials, and the preparation process of the surface layer.

In preferred embodiments, the surface layer of the photovoltaic building material as prepared has a water absorption rate of ≤ 8%. There is no damage or crack after 50 freeze-thaw cycles. The artificial weather aging resistance is ≥ 600 h. The contamination resistance is ≤ 20%. The chemical resistance meets the standard. The scrub resistance is ≥ 1000 times. The adhesion between the surface layer and the power-generating layer is ≥ 1 MPa. The Mohs' hardness of the surface layer is ≥ 3. All of them meet the performance requirements of the surface layer in the construction field.

In preferred embodiments, the combination of the power-generating layer and the substrate layer is a crystalline silicon solar cell module or a thin-film solar cell module.

In preferred embodiments, the crystalline silicon solar cell module comprises a substrate, a gel film, a solar cell layer and a protective layer. The thin-film solar cell module comprises a substrate, a solar cell layer and a protective layer.

In preferred embodiments, the power-generating layer comprises a thin-film solar cell layer and a protective layer.

In preferred embodiments, the solar cell layer and substrate layer are well-known in the art.

In preferred embodiments, the substrate layer is one selected from the group consisting of glass, metal plate, flexible plastic film and ceramic. The power-generating layer is deposited directly on the substrate layer.

In preferred embodiments, the thin-film solar cells used in the power-generating layer comprises copper indium gallium selenide solar cell, gallium arsenide solar cell, amorphous silicon solar cell, cadmium telluride solar cell, dye sensitized solar cell, copper zinc tin sulphur solar cell or perovskite solar cell.

In preferred, the surface layer material comprises a curing mother solution and a filler pigment.

In preferred, the raw material of the surface layer further comprises one or more selected from the group consisting of nanoparticle, quantum dot and graphene.

In preferred embodiments, nanoparticle, quantum dot or graphene is 0.05% to 0.5% of the raw material of the surface layer.

In further preferred embodiments, nanoparticle comprises an inorganic light diffusing agent and/or an organic light diffusing agent.

In preferred embodiments, the raw material for preparing the surface layer mainly comprises a mother solution and is supplemented with pigment.

In preferred embodiments, the mother solution as used is 140 to 200 parts by weight, and the pigment is 5 to 15 parts by weight.

In further preferred embodiments, the mother solution comprises 600 to 800 parts by weight of deionized water, 0.1 to 1 part by weight of cross-linking agents, 2 to 5 parts by weight of cellulose, 0.5 to 3 parts by weight of dispersing agents, 0.5 to 3 parts by weight of multifunctional auxiliary agents, 1 to 4 parts by weight of bactericides, 15 to 30 parts by weight of molding agents, 2 to 6 parts by weight of ethylene glycol, 8 to 10 parts by weight of film-forming auxiliary agents, 15 to 28 parts by weight of soap-free polymerized silicone-acrylic emulsions, 70 to 110 parts by weight of the self-crosslinking silicone-acrylic emulsion via core-shell structure copolymerization and 50 to 110 parts by weight of the silicone grafted acrylate emulsions.

In further preferred embodiments, the pigment comprises 5 to 15 parts of inorganic pigment. The inorganic pigment comprises natural mineral pigment and/or artificial pigment. The natural mineral pigment comprises one or more selected from the group consisting of stone green, carbon black, mica, coral and realgar. The artificial pigment comprises one or more selected from the group consisting of iron oxide red, yellow iron oxide, titanium white, chrome yellow and iron blue.

In further preferred embodiments, the pigment can be an organic pigment. The organic pigment is 5 to 15 parts by weight. The organic pigment comprises one or more selected from the group consisting of azo pigment, phthalocyanine pigment, triarylmethane pigment, and polycyclic pigment.

In further preferred embodiments, the raw material of the surface layer further comprises sand powder. The sand powder comprises one or more selected from the group consisting of quartz sand, kaolin, marble powder and white marble powder.

In preferred embodiments, the mother solution as used is 143 to 296 parts by weight. The pigment is 1 to 10 parts by weight.

In further preferred embodiments, the mother solution comprises 30 to 90 parts by weight of water glasses, 90 to 160 parts by weight of fillers, 0.1 to 0.5 part by weight of anti-foaming agents, 3 to 5 parts by weight of thickeners, 1 to 5 parts by weight of film-forming auxiliary agents, 5 to 9 parts by weight of curing agents and 14 to 27 parts by weight of water. The curing mechanism of the selected liquid material is to absorb carbon dioxide in the air to form an amorphous silicate and gradually dry and solidify.

In further preferred embodiments, the water glass comprises sodium water glass and/or potassium water glass. The filler comprises one or more selected from the group consisting of white carbon black, kaolin, heavy calcium carbonate, light calcium carbonate, wollastonite powder, talc powder, quartz powder, mica, aluminum silicate, precipitated barium sulfate, and bentonite. The anti-foaming agent comprises one or more selected from the group consisting of lower alcohol, mineral oil and silicone resin. The thickener comprises one or more selected from the group consisting of silicone gel, methylcellulose and hydroxypropyl methyl cellulose. The film-forming auxiliary agent comprises dodecyl alcohol ester. The curing agent comprises vinyl triamine and/or m-phenylenediamine M-PDA.

In preferred embodiments, the pigment comprises inorganic pigment and/or organic pigment. The inorganic pigment comprises natural mineral pigment and/or artificial pigment. The natural mineral pigment comprises one or more selected from the group consisting of stone green, carbon black, mica, coral and realgar. The artificial pigment comprises one or more selected from the group consisting of iron oxide red, iron oxide yellow, titanium white, chrome yellow, iron blue, pearl silver, and pearl gold. The organic pigment comprises one or more selected from the group consisting of azo pigment, phthalocyanine pigment, triarylmethane pigment and polycyclic pigment.

In preferred embodiments, the mother solution as used is 75 to 115 parts by weight. The pigment is 1 to 5 parts by weight.

In further preferred embodiments, the mother solution comprises base material, filler and auxiliary agent. The base material is 50 to 70 parts by weight. The filler is 5 to 15 parts by weight. The auxiliary agent is 3 to 6 parts by weight.

In further preferred embodiments, the base material comprises a fluorocarbon resin. The pigment comprises a natural mineral pigment and/or an artificial pigment. The natural mineral pigment comprises one or more selected from the group consisting of stone green, carbon black, mica, coral and realgar. The artificial pigment comprises one or more selected from the group consisting of iron oxide red, yellow iron oxide, titanium white, chrome yellow and iron blue. The filler comprises one or more selected from the group consisting of white carbon black, kaolin, calcium carbonate, wollastonite powder, talc powder, quartz powder, mica powder, silicic acid aluminum, precipitated barium sulfate and bentonite. The auxiliary agent comprises wetting agent, dispersing agent, antifoaming agent, film forming aid, mold inhibitor and thickener.

In preferred embodiments, the wetting agent comprises glycerin and/or dimethyl sulfoxide. The dispersing agent comprises polycarboxylate sodium salt and/or polyacrylic acid ammonium salt. The anti-foaming agent comprises one or more selected from the group consisting emulsified silicone oil, polyoxyethylene polyacrylate quaternary ether and polyoxyethylene polyoxyepropanolamine ether. The film-forming auxiliary agent comprises dodecyl alcohol. The mold inhibitor comprises one or more selected from the group consisting of calcium propionate, ammonium persulfate and o-phenyl phenol. The thickener comprises one or more selected from the group consisting of silicone gel, methyl cellulose and hydroxypropyl methyl cellulose.

In preferred embodiments, the pigment as used comprises thermochromic pigments and/or photochromic pigments.

In preferred embodiments, the protective layer of the photovoltaic building material comprises one or more selected from the group consisting of ceramic film, ethylene-vinyl acetate copolymer (EVA), polyvinyl butyral (PVB), polyethylene-butene copolymer (POE), silica gel, polyethylene (PE), polyethylene-tetrafluoroethylene copolymer (ETFE), perfluoroethylene propylene copolymer (FEP), polyvinylidene fluoride film (PVDF), polyethylene terephthalate (PET), inorganic glass, organic glass (PMMA) and polycarbonate (PC).

When the protective layer only has a ceramic film, the ceramic film as used in the protective layer comprises one or more selected from the group consisting of oxide, nitride and fluoride. The oxide comprises one or more selected from the group consisting of silicon oxide, zinc oxide, and titanium oxide. The nitride comprises aluminum nitride and/or silicon nitride. The fluoride comprises polytetrafluoroethylene.

When the protective layer comprises a gel film, which is one or more selected from the group consisting of EVA, PVB, POE and silica gel, the protective layer further comprises a front film.

The front film comprises a glass and/or a polymer material.

In preferred embodiments, the polymeric material comprises one or more selected from the group consisting of PMMA, PC, ETFE, PVDF, FEP, PET and PET/PE.

In preferred embodiments, the ceramic film has a thickness of 0.4 µm to 1000 µm.

In preferred embodiments, the ceramic film can be prepared by a sputtering method or a chemical vapor deposition method.

In preferred embodiments, the combination of the surface layer, the power-generating layer and a first substrate layer can be adhered to a second substrate. The second substrate layer comprises one or more selected from the group consisting of glass, metal plate, cement-based board, wood board, bamboo board, stone board, concrete board, plastic sheet, ceramic and tile.

The present disclosure provides a process for preparing a photovoltaic building material, comprising:
(1) attaching a power-generating layer to a substrate layer and extracting a positive electrode and a negative electrode; or preparing a power-generating layer directly on a substrate layer and extracting a positive electrode and a negative electrode; or directly using a crystalline silicon solar cell component or a thin-film solar cell component; and
(2) preparing a surface layer on the power-generating layer by directly coating a surface of the power-generating layer with liquid and solidifying.

In preferred embodiments, the substrate layer in the step (1) is washed. The standard washing process is as follows:
Loading → lotion roller brushing and washing → pure water roller brushing and washing → ultrasonic treatment → BJ spraying → pure water spraying → pure water rinsing → air knife drying → Laying off.

The process parameters of each module of the washing machine are as follows:
(1) Roller brushing section: The roller brushing speed is 400 r/min. The upper and lower spraying water pressure is controlled between 1.0 and 1.3 MPa. The ratio by volume of cleaning agent to deionized water is 1:9.
(2) Washing section: The roller brushing speed is 300 r/min. The upper and lower spraying water pressure is controlled between 0.5 and 1.0 MPa.
(3) Ultrasonic section: The ultrasonic frequency is fixed at 18 kHz. The substrate glass must be immersed in the water of ultrasonic section.
(4) BJ spraying section: BJ nozzle must form an angle of 30° with the transmission direction. Water pressure should be controlled at 2 MPa. The air pressure must be greater than 3 MPa.
(5) Pure water spraying section: The upper and lower spray pressure is controlled between 0.5 and 1.2 MPa.
(6) Pure water washing section: The upper and lower spray pressure is controlled between 0.5 and 1.1 MPa.
(7) Air knife section: The pressure of the air knife should be higher than 0.4 MPa.
(8) Destaticization: Static electricity must be removed after the substrate is dried.

In preferred embodiments, the surface layer can be prepared on the power-generating layer with a liquid material by hand spraying, automatic spraying, brushing, spin coating, printing, mimeograph, slurrying, rolling, knife coating or coating.

In preferred embodiments, the curing temperature in the step (2) is -10°C to 100°C, and the curing time is 0.2 s to 48 h.

Some processes for preparing the surface material should be carried out under high temperature conditions, while the high temperature will cause damage to the photovoltaic module. The present disclosure improves the formulation of the surface layer material so that the surface layer material can be cured at a temperature of -10°C to 100°C. In addition, the surface layer can maintain a high transmittance by controlling the thickness and formulation of the surface layer.

The above-mentioned preparation process is carried out at a relatively lower temperature without high temperature treatment, which can effectively reduce energy consumption and ensure that the solar cell is not damaged.

Compared with the prior art, the photovoltaic building materials in the construction field of the present disclosure have the following advantages:
(1) A surface layer is prepared on the surface of the solar cell in the present disclosure so that the surface of the solar cell can exhibit the texture of the conventional building material. The solar cell maintains a high conversion efficiency while ensuring power generation.
(2) The curing temperature of the surface layer as used in the present disclosure is between -10°C and 100°C, which does not cause damage to the photovoltaic module A surface layer with higher hardness can be formed on the photovoltaic module.
(3) The surface layer prepared by the present disclosure not only can be stably combined with the photovoltaic module, but has better wear resistance.
(4) The surface layer prepared by the present disclosure has good weather resistance and can serve for decades as the exterior wall of the building.
(5) The surface layer prepared by the present disclosure has good compactness and corrosion resistance. Therefore, the solar cell wrapped in the surface layer can be effectively separated from the outside.
(6) The power-generating building materials prepared by the present disclosure have stable performance, bright color and good decoration performance. The power-generating building materials have broad application prospect.
(7) The power-generating building materials not only have the function of generating electricity using sunlight, but utilize materials with optical regulation as surface layers, which completely overcomes the shortcomings of light pollution such as flashing, vertigo effects and the like caused by specular reflection of the conventional photovoltaic modules.

### Brief Description of the Drawings

Fig. 1 shows a cross-sectional view of the structure of a novel power-generating building material, in which 1 is a material of the substrate layer (ceramic, cement substrate, metal plate, plastic film, tile, and the like), 2 is a power-generating layer, 3 is an encapsulation layer, and 4 is a protective layer (enamel).
Fig. 2 shows a transmittance curve of different enamel protective layers in the wavelength range of 300 nm to 1300 nm.
Fig. 3 shows an I-V curve of a power-generating building material.
Fig. 4 shows a structural diagram of a photovoltaic building material (comprising a ceramic film), in which 1 is a surface layer, 2 is a power-generating layer and 3 is a substrate layer.
Fig. 5 shows a side view of the structure of the photovoltaic building material shown in Fig. 4, in which 1 is a surface layer, 2-1 is a ceramic film, 2-2 is a solar cell layer, 2*2 is a negative electrode surface, 2*3 is a positive electrode surface, e1 is an extracted negative electrode and e2 is an extracted positive electrode.
Fig. 6 shows a structural diagram of a photovoltaic building material (comprising a front film and a gel film), in which 1 is a surface layer, 2 is a power-generating layer and 3 is a substrate layer.
Fig. 7 shows a side view of the structure of the photovoltaic building material shown in Figure 6, in which 2-1 is a front film, 2-2 is a gel film, 2-3 is a solar cell layer, 2*2 is a negative electrode surface, 2*3 is a positive electrode surface, e1 is an extracted negative electrode and e2 is an extracted positive electrode.
Fig. 8 shows a structural diagram of a photovoltaic building material (comprising a ceramic film and a gel film), in which 1 is a surface layer, 2 is a power-generating layer and 3 is a substrate layer.
Fig. 9 shows a side view of the structure of the photovoltaic building material shown in Figure 8, in which 1 is a surface layer, 2-1 is a ceramic film, 2-2 is a solar cell layer, 3-1 is a gel film, 3-2 is a substrate, 2*2 is a negative electrode surface, 2*3 is a positive electrode surface, e1 is an extracted negative electrode and e2 is an extracted positive electrode.
Fig. 10 shows a structural diagram of a photovoltaic building material (comprising a front film and two gel films), in which 1 is a surface layer, 2 is a power-generating layer and 3 is a substrate layer.
Fig. 11 shows a side view of the structure of the photovoltaic building material shown in Figure 10, which 1 is a surface layer, 2-1 is a front film, 2-2 is a gel film, 2-3 is a solar cell layer, 3-1 is a gel film, 3-2 is a substrate, 2*3 is a negative electrode surface, 2*4 is a positive electrode surface, e1 is an extracted negative electrode and e2 is an extracted positive electrode.
Fig. 12 shows a structural diagram of a photovoltaic building material (comprising a ceramic film and two gel films), in which 1 is a surface layer, 2 is a power-generating layer, 3 is a first substrate layer and 4 is a second substrate layer.
Fig. 13 shows a side view of the structure of the photovoltaic building material shown in Figure 12, in which 1 is a surface layer, 2-1 is a ceramic film, 2-2 is a solar cell layer, 3-1 is a gel film, 3-2 is a first substrate, 4-1 is a gel film, 4-2 is a second substrate, 2*2 is a negative electrode surface, 2*3 is a positive electrode surface, e1 is an extracted negative electrode and e2 is an extracted positive electrode.
Fig. 14 shows a structural diagram of a photovoltaic building material (comprising a front film and three gel films), in which 1 is a surface layer, 2 is a power-generating layer, 3 is a first substrate layer, 4 is a second substrate layer, 2-1 is a front film, 2-2 is a gel film, 2-3 is a solar cell layer, 3-1 is a gel film, 3-2 is a first substrate, 4-1 is a gel film, 4-2 is a second substrate, 2*3 is a negative electrode surface, 2*4 is a positive electrode surface, e1 is an extracted negative electrode and e2 is an extracted positive electrode.
Fig. 15 shows a side view of the structure of the photovoltaic building material shown in Figure 14, in which 1 is a surface layer, 2-1 is a front film, 2-2 is a gel film, 2-3 is a solar cell layer, 3-1 is a gel film, 3-2 is a first substrate, 4-1 is a gel film, 4-2 is a second substrate, 2*3 is a negative electrode surface, 2*4 is a positive electrode surface, e1 is an extracted negative electrode and e2 is an extracted positive electrode.
Fig. 16 shows a transmittance curve of the surface layer of Example 6 of the present disclosure in the wavelength range of 300 nm to 1300 nm. The weighted average transmittance is 85%.
Fig. 17 shows a transmittance curve of the surface layer of Example 7 of the present disclosure in the wavelength range of 300 nm to 1300 nm. The weighted average transmittance is 35%.
Fig. 18 shows a transmittance curve of the surface layer of Example 8 of the present disclosure in the wavelength range of 300 nm to 1300 nm. The weighted average transmittance is 52%.
Fig. 19 shows a transmittance curve of the surface layer of Example 9 of the present disclosure in the wavelength range of 300 nm to 1300 nm. The weighted average transmittance is 10%.

### Detailed Description

The present disclosure will be further explained and illustrated in the following description with reference to the accompanying drawings, which are used only to explain but not to limit the present invention.

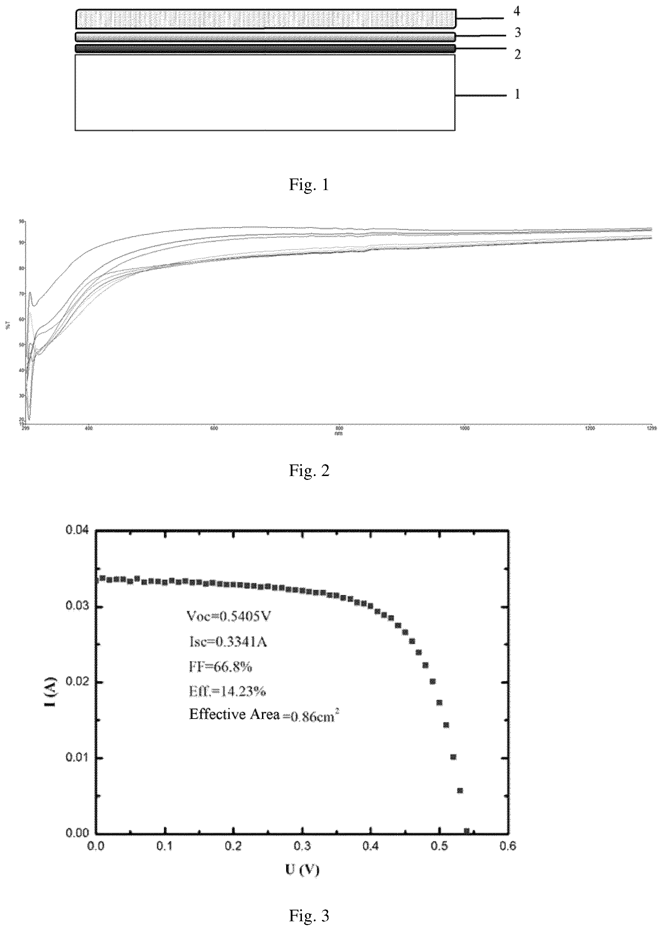

Referring to Fig. 1, a novel power-generating building material is shown.

From bottom to the top, the power-generating building material comprises a substrate layer 1, a thin-film solar cell, a drainage strip 2 and a protective layer 3 (an enamel film).

The substrate material can be glass, ceramic, cement, metal plate, plastic film, tile, and the like.

The thin-film solar cell can be the core structure of a plurality of solar cells. The specific structure can be a structure having a CIGS thin-film solar cell, GaAs thin-film solar cell, amorphous silicon thin-film solar cell, CdTe thin-film solar cell, OPV thin-film solar cell, CZTS thin-film solar cell or perovskite thin-film solar cell.

The protective layer film has an optimum thickness of 0.01 mm to 5 mm. The thicker film will provide better protection, but obviously the transmittance of the protective layer will reduce.

The film can be an enamel film. A film with a gloss glaze, a semi-gloss glaze, a matt glaze or an embossed glaze can used for the power-generating building material. Different colors can be selected for an enamel film as desired. According to the usual practice in the field, the protective layer should be as transparent as possible so that sunlight can pass through at the maximum. While in the present disclosure, by introducing an enamel layer and selectively coloring the enamel layer, the power-generating building material can be integrated into the surrounding environment. This broadens the application of solar cells.

The enamel film as used is preferably an inorganic silicate material or an inorganic-organic composite material. The composition thereof comprises a plurality of elements selected from the group consisting of O, Na, Ga, Mg, S, Si, Al, Ca, Co, K, Zr, Ba, P and B. A glaze can be formed by reacting a raw material comprising these elements (such as an oxide or a corresponding salt, for example sodium silicate, magnesium hydroxide and potassium carbonate) at a low temperature.

Taking the preparation of glaze 0.05MgSO₄·0.05CaO·0.15ZrO·0.70N a₂SiO₃·0.05Al₂(SO₄)₃ as an example, the raw materials are accurately weighed according to the raw material component ratio of the above glaze. 30-35% by weight of water is added. The resultant mixture is ball milled over 36 h to 40 h to achieve the glaze fineness of 250 mesh and sieve residue of less than 0. 015%. As a result, a qualified glaze abrasive is obtained.

The raw material can also be selected from sodium titanate, quartz sand, feldspar powder, sodium carbonate, sodium nitrate, cryolite, zirconium dioxide, aluminum phosphate, cobalt nitrate, nickel nitrate, zinc oxide, barium carbonate, and the like as a source of different oxides.

The abrasive is sintered at a high temperature (such as 800 to 850°C), quenched and pulverized to obtain an enamel glaze. The glaze can be ball milled to obtain fine particles in order to be applied to inkjet printing or sprayed directly.

Other components of the glaze that can be used may also be 0.06MgSO₄·0.10CaO·0.12ZrO·0.64Na₂SiO₃·0.05Al₂(SO₄)₃·0.03Co₂O₃, 0.06BaSO₄ ·0.11CaO·0.13TiO₂·0.65Na₂SiO₃·0.04Al₂(SO₄)₃·0.01Co₂O₃, 0.10BaSO₄·0.10TiO₂·0.75K₂SiO₃·0.04Al₂(SO₄)₃·0.01Co₂O₃, 0.06MgSO₄·0.10TiO₂·0.12ZrO·0.605K₂SiO₃·0.085Al₂(SO₄)₃0.03CoCl₂, 0.08BaO·0.10Ga₂O₃·0.12ZrO·0.565K₂SiO₃·0.085Al₂(SO₄)₃·0.03COCl₂·0.02B₂O₃, and the like.

In the following examples, the aqueous glaze may be any one of the above materials.

Various dopants can be added in the above-mentioned film so that light can transmit in a specific wavelength range. For example, benzotriazoles are added as ultraviolet absorbers. The absorption of ultraviolet light can be ac hieved by adding one or more selected from the group consisting of 2-(2'-hydr oxy-5' -methyl)-benzotriazole, 2-(2' -hydroxy-3' -tert-butyl-5' -methyl)-5-chloro-benzo triazole, 2-(2'-hydroxy-3'5'-di-tert-butyl)-5-chloro-benzotriazole, 2'-(2'-hydroxy-3'-tert-butyl-5'-methylphenyl)-5-chlorobenzotriazole and 2-(2'-hydroxy-5'-tert-octyl)-b enzotriazole. The regulation of near-infrared light can be achieved by adding o ne or more selected from the group consisting of indium tin oxide, antimony t in oxide, tungsten trioxide, molybdenum trioxide, tungsten bronze and copper s ulfides with oxygen deficiency. The regulation of visible light absorption can b e achieved by adding fullerene derivative PC61BM or PC71BM (see CN 1060 25080 A) or other colored materials.

The film can also be a fluorine-containing polymer. The typical fluorine-containing polymer is polytetrafluoroethylene. When a fluorine-containing polymer with a thickness of 0.01 to 1 mm is used as a protective layer, it not only can ensure light transmission, but can change the appearance of a solar cell.

The film of a protective layer has a transmittance of 0% to 79% in a wavelength range of 300 nm to 1300 nm. One skilled in the art can further improve this as desired. For example, specific components can be added or doped in the film, so that light at specific wavelength range can be absorbed or high transmittance can be maintained. Referring to the absorption spectrum of the enamel layer material as shown in Fig. 2, there is the transmittance of 0% to 79% in at least one of the following wavelength ranges: 300 to 400 nm, 400 to 500 nm, 500 to 600 nm, 600 to 700 nm, 700 to 760 nm, 760 to 860 nm and 860 to 1300 nm. In addition, the transmittance of visible light and light of 760 to 1300 nm decreases from top to bottom in turn in accordance with the different types of the films.

Fig. 3 shows an I-V curve of a power-generating building material with the structure shown in Fig. 1. As shown in Fig. 3, the conversion efficiency of a small-area power-generating building material is greater than 14%.

### Example 1

A power-generating building material comprised a substrate, which was a flexible stainless steel foil and had a thickness of 0.2 mm. A power-generating electrode layer was disposed on the substrate and had wires to extract electrodes. A protective layer was disposed on a cell layer. The protective layer was made with an aqueous glaze. The aqueous glaze comprised a soluble silicon inorganic metal salt. The protective layer had a thickness of 0.1 mm and marble patterns.

The preparation process was as follows:
The flexible stainless steel foil substrate was washed and placed in a magnetron sputtering machine. In order to prevent the elements in the stainless steel from diffusing into the solar cell, firstly, a 0.5 µm WTi barrier layer was sputtered. The working gas was Ar gas. The sputtering gas pressure was 0.7 Pa. The background vacuum was 2.0×10⁻³ Pa. The substrate was not heated during sputtering. The Mo film was prepared by a three-sublayer process. The sputtering pressure of the first layer was 1.5 Pa. The sputtering pressure of the second layer was 0.6 Pa. The sputtering pressure of the third layer was 1.5 Pa. A 2 µm CIGS film was deposited by sputtering on the Mo film at a sputtering gas pressure of 0.7 Pa and a background vacuum of 1.5×10⁻³ Pa, followed by selenization annealing treatment. The selenized film was placed in a mixed solution of cadmium sulfate, thiourea, and ammonia, 50 nm CdS was deposited at 70°C. Then, the film was placed in the sputtering chamber again. The working gas was O₂ and Ar. The sputtering pressure was 0.7 Pa. The background vacuum was 2.0×10⁻³ Pa. The substrate temperature was kept at 200°C during sputtering. Intrinsic ZnO film and AZO film were deposited, separately. Finally, a Ni-Al gate was deposited by evaporation to prepare a flexible thin-film solar cell panel.

The protective layer was prepared by inkjet printing. The raw materials of the enamel layer comprised cobalt acetate, ferrous chloride, potassium chromate and zirconium hypochlorite. The glaze solution was prepared by a conventional process (dissolving with water or an alcohol solvent and adding OP and aqueous acrylic emulsion). The glaze solutions were loaded into different printer equipment according to different colors of the glazes and printed directly according to the patterns of the marble to obtain the power-generating building material.

The power-generating building material had a marble pattern. The transmittance in visible light at 500 nm to 700 nm was 71% and the photovoltaic conversion efficiency was 14.6%.

### Example 2

A power-generating building material comprised a substrate, which was ceramic with a thickness of 8.0 mm. A cell layer was disposed on the substrate and had wires to extract electrodes. The solar cell layer had a CdTe solar cell structure.

The specific preparation process was as follows.

Firstly, a washed substrate was placed in a sputtering apparatus. The working gas was Ar gas. The sputtering gas pressure was 0.7 Pa. The background vacuum was 1.5×10⁻³ Pa. A transparent conductive indium tin oxide thin-film was sputtered and deposited on the substrate. Subsequently, a CdS slurry was coated to form a film by screen-printing method. The film was dried at 120°C for 3 h and sintered in a nitrogen atmosphere for 2 h at a sintering temperature of 650°C. A slurry containing CdTe powder was printed on the CdS film and sintered for 1 h. Finally, a carbon electrode and Ag slurry were printed on CdTe as extraction electrodes. A protective layer was disposed on the cell layer. The protective layer was made with an aqueous glaze. The aqueous glaze comprised a soluble inorganic metal salt. The protective layer had a thickness of 0.1 mm and marble patterns.

The glaze solution can be coated on the surface of the cell layer by spray coating, screen printing or flow impeller. The transmittance of light at 450 nm to 760 nm was 52%. The obtained cell has a photoelectric conversion efficiency of not less than 14.1% and can be used on the exterior walls of buildings.

### Example 3

A power-generating building material comprised a substrate, which was an aluminum nitride ceramic with a thickness of 1.0 cm. A cell layer was disposed on the substrate, and had wires to extract electrodes. An encapsulation layer and a protective layer were disposed on the cell layer. The protective layer was made with a polytetrafluoroethylene and had a thickness of 0.05 mm. The surface of the protective layer was dark gray. The surface of a power-generating layer had 4 or less layers of graphene.

For the preparation of the cell, refer to Example 1. The graphene layer can be prepared at low temperature. In order to avoid adverse effects on the power-generating layer, the graphene layer must be prepared at a temperature of not higher than 400 °C.

The cell obtained in the present Example had a light transmittance of 21% at 450 nm to 760 nm and a photoelectric conversion efficiency of not less than 14.0%. The power-generating building material can be used on the exterior walls of buildings.

### Example 4

A power-generating building material comprised a substrate, which was a polyimide film. A cell layer was disposed on the substrate and had wires to extract electrodes. An encapsulation layer and a protective layer were disposed on the cell layer. The protective layer was made with polytetrafluoroethylene and had a thickness of 0.05 mm. The surface of the protective layer was beige. See embodiment 1 for the preparation of the solar cell.

The cell obtained in the present Example had a light transmittance of 50% at 500 nm to 760 nm and a photoelectric conversion efficiency of not less than 14.2%.

### Example 5

A power-generating building material comprised a substrate, which was enamel. A cell layer was disposed on the substrate and had wires to extract electrodes. A protective layer was disposed on the cell layer. The protective layer was made with polytetrafluoroethylene and had a thickness of 0.6mm. The surface of the protective layer was white. Refer to Example 1 for the preparation of the cell. The surface of the cell was covered with graphene. The number of graphene layer was not more than 15. The graphene layers can be prepared by low temperature method. In order to avoid interference with the power-generating layer, the graphene layers must be prepared at a temperature of not higher than 400 °C.

The cell obtained in the present Example had a light transmittance of 76% at 450 nm to 760 nm and a photoelectric conversion efficiency of not less than 14.2%.

### Example 6

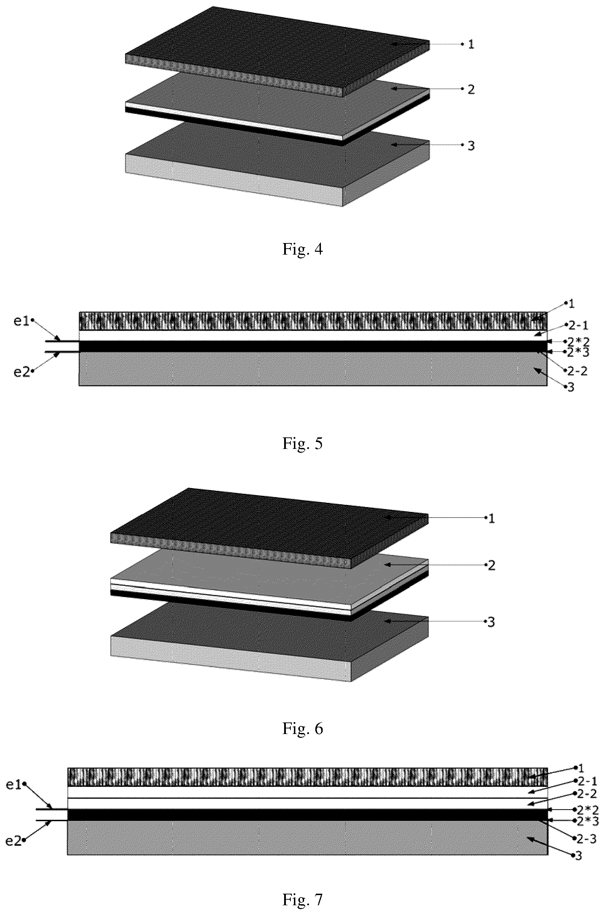

Figs. 4 and 5 show a photovoltaic building material.

From top to bottom, a photovoltaic building material comprised a surface layer, a power-generating layer and a substrate layer.

The substrate was a flexible stainless steel foil and had a thickness of 0.2 mm. The power-generating layer was disposed on the substrate and had wires to extract electrodes. The surface layer was disposed on the power-generating layer.

The process for preparing the power-generating layer was as follows.

The flexible stainless steel foil substrate was washed and placed in a magnetron sputtering machine. In order to prevent the elements in the stainless steel from diffusing into the solar cell, firstly, a 1.0 m WTi barrier layer was sputtered. The working gas was Ar gas. The sputtering gas pressure was 0.7 Pa. The background vacuum was 2.0×10⁻³ Pa. The substrate was not heated during sputtering. A Mo film was prepared by a three-sublayer process. The sputtering pressure of the first layer was 1.5 Pa. The sputtering pressure of the second layer was 0.6 Pa. The sputtering pressure of the third layer was 1.5 Pa. A 1.2 µm CIGS film was deposited by sputtering on the Mo film at a sputtering gas pressure of 0.7 Pa and a background vacuum of 1.5×10⁻³ Pa, followed by selenization annealing treatment. The selenized film was placed in a mixed solution of cadmium sulfate, thiourea, and ammonia. 30 nm CdS was deposited at 70 °C. Then, the film was placed in the sputtering chamber again. The working gas was O₂ and Ar. The sputtering pressure was 0.7 Pa. The background vacuum was 2.0×10⁻³ Pa. The substrate temperature was kept at 200°C during sputtering. Intrinsic ZnO film and AZO film were deposited, separately. Finally, a Ni-Al gate was deposited by evaporation to prepare a flexible thin-film solar cell panel. A layer of aluminum nitride with a thickness of 15 µm was deposited by RF sputtering to finally prepare the power-generating layer.

The surface layer was prepared by printing method. The surface layer mainly comprised a mother liquid and supplemented with an inorganic pigment. Based on parts by weight, the mother solution accounted for 155 parts, the pigment accounted for 7 parts. The pigment was titanium dioxide and iron oxide red powder with the same weights. The mother solution comprised 764 parts of deionized water, 0.4 parts of A1522 cross-linking agent, 3 parts of 250HBR cellulose, 1.5 parts of 5040 dispersing agent, 1.5 parts of AMP-95 multifunctional auxiliary agent, 2.5 parts of M30 bactericide , 21 parts of R103 forming agent, 4 parts of ethylene glycol, 9.5 parts of C-12 film-forming auxiliary agent, 0.1 part of silicone light diffusing agent, 0.02 parts of semiconductor ceria quantum dot, 0.001 parts of graphene, 21 parts of soap-free polymerized silicone-acrylic emulsion, 90 parts of core-shell copolymerized self-crosslinking silicone-acrylic emulsion and 70 parts of silicone grafted acrylate emulsion. The thickness of the prepared surface layer was 0.01 mm. The curing temperature was 90°C. The curing time was 1 h.

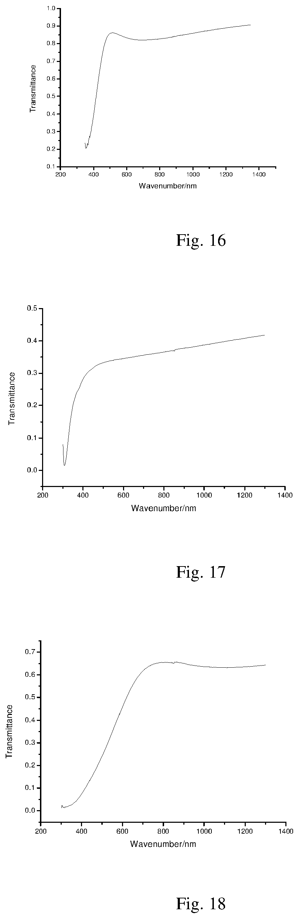

In accordance with the transmittance curve of visible light at 300 nm to 1300 nm as shown in Fig. 16, the surface layer of the photovoltaic building material had a weighted average transmittance of 85%.

### Example 7

Figs. 6 and 7 show a photovoltaic building material.

From top to bottom, a photovoltaic building material comprised a surface layer, a power-generating layer and a substrate layer.

A photovoltaic building material comprised the substrate, which was glass and had a thickness of 2.0 mm. A cell layer was disposed on the substrate and had wires to extract electrodes. The process for preparing the cell was similar to that of Example 1, except that the CIGS film was replaced with Cu₂(ZnSn)(SSe)₄ and the post-treatment process of the film was replaced with selenization or vulcanization. A protective layer was disposed on the cell layer. The protective layer was EVA and glass. The surface layer was prepared by manual spraying method.

Based on parts by weight, 186 parts of mother solution and 5 parts of pigment were used. The mother solution as used comprised 45 parts of potassium water glass, 130 parts of filler, which was a mixture of talc powder, calcium carbonate and kaolin with the weight ratio of 2:1:1, 0.2 part of silicone resin, 3 parts of silicone gel, 1 part of lauryl alcohol ester, 6 parts of vinyltriamine, 20 parts of water, and 0.2 part of barium sulfate light diffusing agent. The pigment was a mixture of stone green and realgar with the weight ratio of 1:3. The thickness of the obtained surface layer was 2 mm. The curing temperature was 20°C. The curing time was 2 h.

In accordance with the transmittance curve of visible light at 300 nm to 1300 nm as shown in Fig. 17, the surface layer of the photovoltaic building material had a weighted average transmittance of 35%.

### Example 8

Figs 6 and 7 show a photovoltaic building material.

From top to bottom, a photovoltaic building material comprised a surface layer, a power-generating layer and a substrate layer.

A photovoltaic building material comprised the substrate, which was ceramic and had a thickness of 8.0mm. A cell layer was disposed on the substrate and had wires to extract electrodes. The cell layer had a CdTe solar cell structure.

The specific preparation process was as follows.

Firstly, the washed substrate was placed in a sputtering apparatus. The working gas was Ar gas. The sputtering gas pressure was 0.7 Pa. The background vacuum was 1.8×10⁻³ Pa. A transparent conductive indium tin oxide thin-film was sputtered and deposited on the substrate. Subsequently, a CdS slurry was coated to form a film by screen printing method. The film was dried at 100□ for 2 h and sintered in a nitrogen atmosphere for 2 h at 680□. A slurry comprising CdTe powder was printed on the CdS film and sintered for 1 h. Finally, a carbon electrode and an Ag slurry were printed on CdTe as extraction electrodes. A protective layer was disposed on the cell layer. The protective layer was PVB and ETFE. The surface layer was prepared on the protective layer. The thickness of the surface layer was 0.1 mm. The raw materials of the surface layer were as follows.

Based on parts by weight, 100 parts of mother solution and 5 parts of pigment were used. The raw materials of the mother solution comprised base material, filler and auxiliary agent. The base material accounted for 60 parts. The filler accounted for 15 parts. The auxiliary agent accounted for 3.8 parts. The base material comprised a fluorocarbon resin. The pigment used natural mineral pigments. The natural mineral pigments comprised mica and coral. The filler comprised wollastonite powder, quartz powder and bentonite with the weight ratio of 1:1.5:0.8. The auxiliary agent comprised 0.2 parts of sulfoxide, 1.1 parts of sodium carboxylate, 0.3 parts of emulsified silicone oil, 1.5 parts of dodecyl alcohol, 0.2 parts of o-phenylphenol and 0.5 parts of methyl cellulose.

The liquid raw materials constituting the surface layer were coated on the surface of the cell layer by flow impeller method. The curing temperature was 100°C. The curing time was 0.2 s.

In accordance with the transmittance curve of visible light at 300nm to 1300 nm as shown in Fig. 18, the surface layer had a weighted average transmittance of 52%.

### Example 9

Figs 4 and 5 show a photovoltaic building material.

From top to bottom, a photovoltaic building material comprised a surface layer, a power-generating layer and a substrate layer.

A photovoltaic building material comprised a substrate, which was aluminum nitride ceramic and had a thickness of 20.0mm. A cell layer, which was amorphous silicon cell, was disposed on the substrate and had wires to extract electrodes. A protective layer was disposed on the cell layer. The protective layer was made with a silica ceramic film and had a thickness of 5 µm. The silica was prepared by reactive sputtering. The reactive sputtering was carried out after the vacuum chamber was pumped to pressure of 2.0×10⁻³ Pa. The sputtering was carried out under the constant power sputtering of 600 W, the sputtering gas pressure of 0.6 Pa, the sputtering atmosphere of Ar and O₂, wherein Ar : O₂ was 3:1. The target was monocrystalline silicon with 6 N purity. The target base distance was 60 mm.

The surface layer was prepared by printing method. Based on parts by weight, a mother solution accounted for 240 parts, and pigment accounted for 10 parts. The mother solution as used comprised 75 parts of sodium water glass, 112 parts of filler, which was a mixture of talc powder, aluminum silicate and kaolin with the weight ratio of 3:2:5, 0.1 parts of silicone resin, 5 parts of methylcellulose, 5 parts of dodecyl alcohol ester, 6 parts of m-phenylenediamine, 14 parts of water, and 0.05 parts of a silicone light diffusing agent. The pigment was phthalocyanine pigment. The thickness of the obtained surface layer was 0.5 mm. The curing temperature was -10°C. The curing time was 48 h.

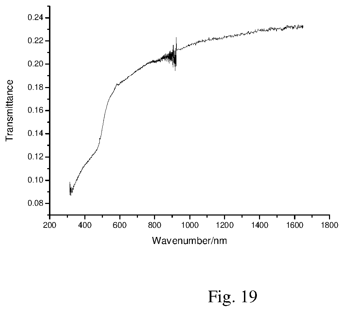

In accordance with the transmittance curve of visible light at 300 nm to 1300 nm as shown in Fig. 19, the surface layer of the photovoltaic building material had a weighted average transmittance of 45%.

### Example 10

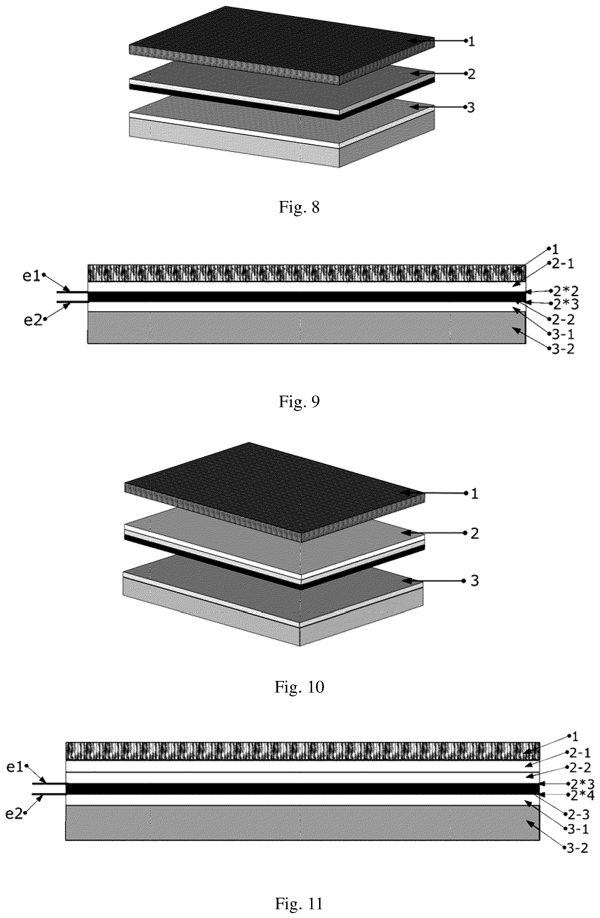

Figs. 8 and 9 shows a photovoltaic building material.

From top to bottom, a photovoltaic building material comprised a surface layer, a power-generating layer and a substrate layer.

A photovoltaic building material used polycrystalline silicon components. The substrate was ceramic and had a water absorption rate of less than 1% and a thickness of 5 mm. The power-generating layer had wires to extract electrodes. A protective layer was disposed on the cell layer. The protective layer was a silica ceramic film.

The surface layer was prepared by automatic spraying method. The raw materials comprised a mother solution and a pigment. Based on parts by weight, the mother solution accounted for 75 parts, and the pigment accounted for 1 part. The raw materials of the mother solution comprised base material, filler and auxiliary agent. The base material accounted for 70 parts. The filler accounted for 10 parts. The auxiliary agent accounted for 6 parts. The base material was fluorocarbon resin. The pigment was artificial pigment. The artificial pigment was iron blue. The filler comprised quartz powder and precipitated barium sulfate. The auxiliary agent comprised 0.4 parts of glycerin, 1.0 part of sodium polycarboxylate, 0.4 parts of Polyoxyethylene polyoxyepropanolamine ether, 2 parts of lauryl alcohol, 0.1 part of ammonium persulfate and 0.6 parts of hydroxypropyl methylcellulose.

The liquid raw materials constituting the surface layer were coated on the surface of the cell layer by printing. The thickness of the surface layer was 0.3 mm. The curing temperature was 50°C. The curing time was 1 s. The surface layer had a weighted average transmittance of visible light at 300 nm to 1300 nm of 45%.

### Example 11

Figs 10 and 11 show a photovoltaic building material.

From top to bottom, a photovoltaic building material comprised a surface layer, a power-generating layer and a substrate layer in turn.

A photovoltaic building material used a commercially available monocrystalline silicon solar cell module. The substrate was a glass and had a thickness of 2 mm. The power-generating layer had wires to extract electrodes and a protective layer. The protective layer comprised a silica gel and a front film. The front film was ETFE.

The surface layer was prepared by spin coating method. The raw materials comprised a mother solution and a pigment. Based on parts by weight, the mother solution accounted for 140 parts, and the pigment accounted for 5 parts.

The mother solution comprised 800 parts of deionized water, 0.3 part of A151 cross-linking agent, 2 parts of 250HBR cellulose, 0.5 part of 5040 dispersing agent, 3 parts of AMP-95 multifunctional auxiliary agent, 1 part of M30 bactericide, 15 parts of R103 forming agent, 6 parts of ethylene glycol, 8 parts of C-12 film-forming auxiliary agent, 0.1 part of nano-silica light diffusing agent, 28 parts of soap-free polymerized silicone-acrylic emulsion, 70 parts of the self-crosslinking silicon-acrylic emulsion copolymerized by core-shell structure, and 110 parts of silicone grafted acrylate emulsion. Pigment was azo pigment and accounted for 1 part. The thickness of the prepared surface layer was 0.05 mm. The curing temperature was -10 °C. Tthe curing time was 30 h.

The product prepared in the present Example had a weighted average light transmittance of 55% at 300 nm to 1300 nm.

### Example 12

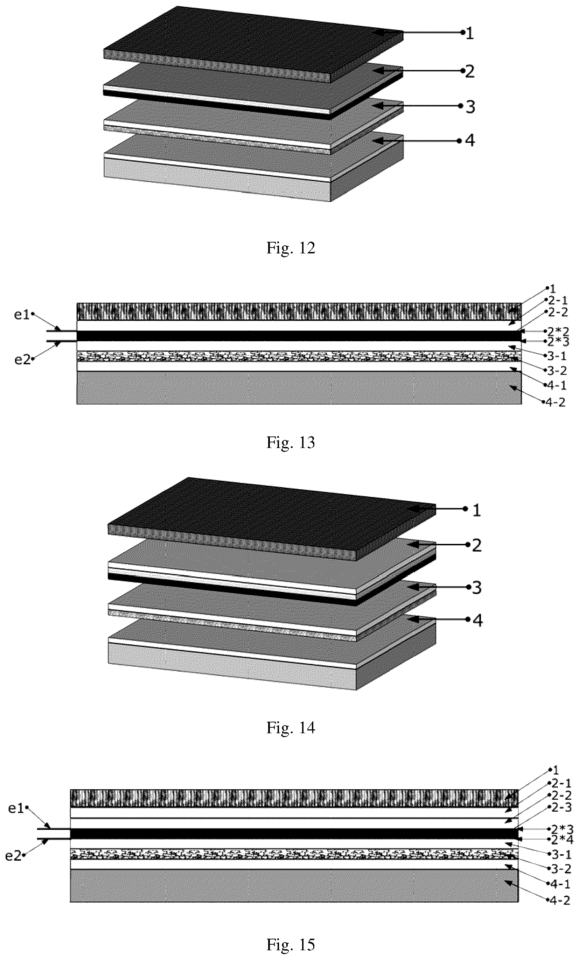

Figs 12 and 13 show a photovoltaic building material.

From top to bottom, a photovoltaic building material comprised a surface layer, a power-generating layer, a first substrate layer and a second substrate layer in turn.

For a photovoltaic building material, a power-generating layer was a monocrystalline silicon solar cell module. The module was adhered to a tile. The module had wires to extract electrodes. A surface layer was disposed on the power-generating layer.

Example 7 was referred to for the process for preparing the surface layer.

### Example 13

Figs. 14 and 15 show a photovoltaic building material.

From top to bottom, a photovoltaic building material comprised a surface layer, a power-generating layer, a first substrate layer and a second substrate layer in turn.

For a photovoltaic building material, a power-generating layer was a monocrystalline silicon solar cell module. The module was adhered to a ceramic. The module had wires to extract electrodes. A surface layer was disposed on the power-generating layer.

Example 9 was referred to for the process for preparing the surface layer.

### Example 14

From top to bottom, a photovoltaic building material comprised a surface layer, a power-generating layer, a first substrate layer and a second substrate layer in turn.

The power-generating layer was an amorphous silicon thin-film solar cell module. The module was adhered to a cement substrate. The module had wires to extract electrodes. A surface layer was disposed on the power-generating layer.

Example 8 was referred to for the process for preparing the surface layer.

It should be noted that the above embodiments are merely illustrating rather than limiting the technical solutions of the present disclosure. Although the disclosure has been described in detail herein with reference to the embodiments, one skilled in the art should understand that modifications and equivalent replacements of the technical solution of the present disclosure without departing from the spirit and scope of the technical solutions of the present disclosure will fall within the scope of the claims.

## Claims

1. A power-generating building material, comprising a substrate, a power-generating layer and a protective layer, wherein
the power-generating layer is disposed on the substrate,
the protective layer covers the power-generating layer;
the substrate is glass, metal plate, cement-based board, flexible plastic film, ceramic or tile, and
the protective layer has a weighted average transmittance of 0% to 79% in a wavelength range of 300 nm to 1300 nm.

2. The power-generating building material of claim 1, wherein the substrate layer has a thickness of 0.01 mm to 5 cm.

3. The power-generating building material of claim 1, wherein the power-generating layer has a structure of copper indium gallium selenide thin-film solar cell, gallium arsenide solar cell, crystalline silicon solar cell, silicon based thin-film solar cell, cadmium telluride thin-film solar cell, organic solar cell, copper zinc tin sulfur thin-film solar cell or perovskite thin-film solar cell.

4. The power-generating building material of claim 1, wherein the protective layer is made with an inorganic silicate material or an inorganic-organic composite material.

5. The power-generating building material of claim 1, wherein the protective layer has a thickness of 0.01 mm to 5 mm.

6. The power-generating building material of claim 1, wherein the solar cell further comprises an encapsulation layer located between the power-generating layer and the protective layer, the encapsulation layer comprises an ethylene-octene copolymer or an ethylene-vinyl acetate copolymer.

7. The power-generating building material of claim 6, wherein the encapsulation layer has a thickness of 0.05 mm to 3 mm.

8. A process for preparing the power-generating building material of any one of claims 1 to 7, comprising:
(1) attaching the power-generating layer to the substrate and extracting a positive electrode and a negative electrode, or directly preparing the power-generating layer on the substrate, and extracting a positive electrode and a negative electrode; and
(2) coating a protective layer material at liquid state at room temperature and curing at room temperature over 8 hours to 12 hours to form a solid enamel protective layer.

9. The process of claim 8, wherein the substrate is treated with polishing and cleaning before preparing the power-generating layer, and the treated substrate has a surface roughness of less than 100 nm and a contact angle of 5° to 15°.

10. The process of claim 8, wherein the step (1) further comprises forming an encapsulation layer after extracting the positive electrode and negative electrode.

11. A photovoltaic building material, comprising a surface layer, a power-generating layer and a substrate layer, wherein the surface layer is formed by coating a liquid directly on a surface of the power-generating layer and solidifying, and the surface layer has a weighted average transmittance of 10% to 85% in a wavelength range of 300 nm to 1300 nm.

12. The photovoltaic building material of claim 11, wherein the surface layer has a thickness of 0.01 mm to 5 mm.

13. The photovoltaic building material of claim 11, wherein the surface layer has a weighted average transmittance of 45% to 75% in a wavelength range of 300 nm to 1300 nm and a haze of 10% to 99%.

14. The photovoltaic building material of claim 11, wherein a raw material of the surface layer comprises a curing mother solution and a filling pigment.

15. The photovoltaic building material of claim 14, wherein the raw material of the surface layer further comprises one or more selected from the group consisting of nanoparticle, quantum dots and graphene.

16. The photovoltaic building material of claim 11, wherein a combination of the power-generating layer and the substrate layer is a crystalline silicon solar cell module or a thin-film solar cell module.

17. The photovotaic building material of claim 11, wherein the power-generating layer comprises a solar cell layer and a protective layer.

18. The photovotaic building material of claim 11 or 17, wherein
the substrate layer comprises one or more selected from the group consisting of glass, metal plate, flexible plastic film and ceramic; and
the solar cell layer of the power-generating layer comprises copper indium gallium selenide solar cell, gallium arsenide solar cell, amorphous silicon solar cell, cadmium telluride solar cell, dye-sensitized solar cell, copper zinc tin sulfide solar cell or perovskite solar cell.

19. The photovoltaic building material of claim 17, wherein
the protective layer comprises one or more selected from the group consisting of ceramic film, ethylene-vinyl acetate copolymer, polyvinyl butyral, polyethylene-butene copolymer, silica gel, polyethylene, polyethylene-tetrafluoroethylene copolymer, perfluoroethylene propylene copolymer, polyvinylidene fluoride, polyethylene terephthalate, inorganic glass, organic glass and polycarbonate;
the protective layer only has ceramic film; or
when the protective layer comprises one or more selected from the group consisting of ethylene-vinyl acetate copolymer, polyvinyl butyral, polyethylene oxide and silica gel, the protective layer further comprises a front film;
the front film comprises inorganic glass and/or polymer material.

20. The photovoltaic building material of claim 19, wherein the polymer material comprises one or more selected from the group consisting of organic glass, polycarbonate, ethylene-tetrafluoroethylene copolymer, polyvinylidene fluoride film, perfluoroethylene propylene copolymer, polyethylene terephthalate and polyethylene terephthalate/polyethylene.

21. A process for preparing a photovoltaic building material, comprising
(1) attaching a power-generating layer to a substrate layer and extracting a positive electrode and a negative electrode, or preparing a power-generating layer directly on a substrate layer and extracting a positive electrode and a negative electrode, or directly using a crystalline silicon solar cell module or a thin-film solar cell module; and
(2) preparing a surface layer on the power-generating layer by directly coating a surface of the power-generating layer with liquid and solidifying.

22. The process of claim 21, wherein the surface layer has a curing temperature of -10°C to 100°C and a curing time of 0.2 s to 48 h.
